# FASCICULE DE BREVET EUROPEEN

(11) **EP 1 881 598 B1**
(45) Date de publication et mention de la délivrance du brevet: **25.04.2012**
(21) Numéro de dépôt: 07111819.4
(22) Date de dépôt: 05.07.2007
(51) Int. Cl.: H03F 1/30, H03F 3/20, H03F 1/52

(54) **Dispositif de filtrage d'un circuit d'alimentation électrique notamment pour amplificateur audio sur véhicule automobile**
Filtervorrichtung eines elektrischen Stromkreises, insbesondere für Audioverstärker an Kraftfahrzeugen
Device for filtering a power supply circuit, in particular for an audio amplifier in an automobile vehicle

(30) Priorité: 07.07.2006 FR 0606208
(43) Date de publication de la demande: 23.01.2008
(73) Titulaire: MAGNETI MARELLI FRANCE, 78190 Trappes (FR)
(72) Inventeur: DAPREMONT, OLIVIER, 86100, CHATELLERAULT (FR); MERCIER, Sylvain, 37270, MONTLOUIS SUR LOIRE (FR)
(74) Mandataire: Texier, Christian

(56) Documents cités:
- HIRACHI K ET AL: "A specific control implementation on back-type active power filtering converters" TELECOMMUNICATIONS ENERGY CONFERENCE, 1995. INTELEC '95., 17TH INTERNATIONAL THE HAGUE, NETHERLANDS 29 OCT.-1 NOV. 1995, NEW YORK, NY, USA,IEEE, US, 29 octobre 1995 (1995-10-29), pages 444-449, XP010161274 ISBN: 0-7803-2750-0

## Description

### DOMAINE TECHNIQUE DE L'INVENTION

La présente invention concerne le domaine des filtres pour circuits d'alimentation électrique.

La présente invention s'applique en particulier au filtrage d'un amplificateur audio embarqué sur un véhicule automobile et alimenté par la batterie de ce véhicule.

### ETAT DE LA TECHNIQUE

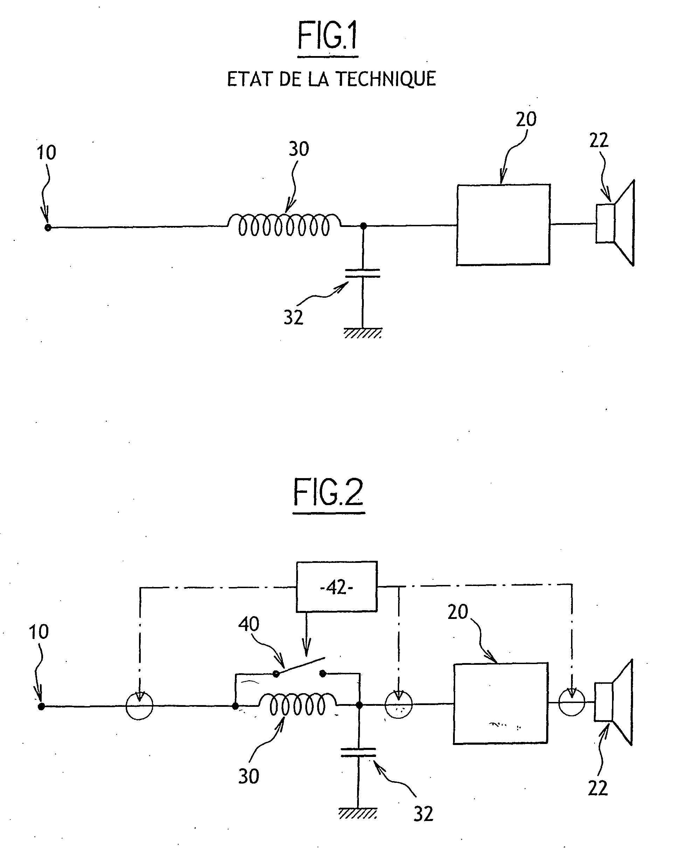

On a représenté sur la figure 1 annexée un dispositif de filtrage classique connu de l'état de la technique.

Sur la figure 1 on a référencé 10 la sortie positive d'une batterie de véhicule, 20 un amplificateur audio et 22 un haut parleur ou équivalent connecté en sortie de l'amplificateur audio 20.

On aperçoit par ailleurs sur la figure 1 un filtre connu comprenant d'une part une inductance ou self 30 placée en série entre la sortie 10 de la batterie et l'entrée de l'amplificateur 20 et d'autre part une capacité 32 connectée entre la masse et le point commun à la self 30 et à l'entrée de l'amplificateur 20.

Les dispositifs de filtrage du type illustré sur la figure 1 annexée ont déjà rendu de grands services. Ils permettent de filtrer l'alimentation de l'amplificateur 20 car la tension batterie d'un véhicule automobile est très bruitée et par ailleurs les amplificateurs audio disponibles sur le marché ont généralement une faible réjection de l'alimentation.

Cependant les dispositifs de filtrage connus présentent un encombrement significatif, notamment en raison de la présence de la self qui doit être dimensionnée pour supporter les intensités maximales consommées par l'amplificateur 20.

Typiquement les dispositifs de filtrage connus utilisent à cette fin des selfs 10A à montage manuel.

Le document Hirachi K. " A specific control implementation on back-type active power filtering converters" décrit un dispositif de filtrage d'une alimentation électrique comprenant une self, un interrupteur placé en parallèle avec la self et un moyen de mesure d'un paramètre représentatif de la puissance consommée par un module de sortie et de fermeture de l'interrupteur. Ladite self ainsi qu'une capacité connectée à ladite self constituent un filtre passe-bas de type LC.

### BASE DE L'INVENTION

La présente invention qui concerne un dispositif de filtrage selon la revendication 1 a maintenant pour but de proposer un nouveau dispositif de filtrage permettant d'éliminer les inconvénients de l'état de la technique.

La présente invention a en particulier pour but de proposer un nouveau dispositif de filtrage présentant un encombrement plus faible que les amplificateurs antérieurement connus.

Le but précité est atteint dans le cadre de la présente invention, grâce à un dispositif de filtrage d'une alimentation électrique comprenant une self, un interrupteur placé en parallèle de la self et un moyen de mesure d'un paramètre représentatif de la puissance consommée par un module de sortie et à fermer l'interrupteur pour court-circuiter la self lorsque ladite puissance consommée est supérieure à un seuil.

La présente invention concerne également les amplificateurs incorporant un tel dispositif de filtrage ainsi que les véhicules ainsi équipés.

### DESCRIPTIF RAPIDE DES FIGURES

D'autres caractéristiques, buts et avantages de la présente invention apparaîtront à la lecture de la description détaillée qui va suivre et en regard des dessins annexés, donnés à titre d'exemples non limitatifs et sur lesquels :
- la figure 1 précédemment décrite représente un circuit de filtrage connu de l'état de la technique, et
- la figure 2 représente un filtre conforme à la présente invention.

### DESCRIPTION DETAILLEE DE L'INVENTION

On retrouve sur la figure 2 annexée la borne de sortie positive 10 d'une batterie de véhicule automobile, un amplificateur audio 20 associé à une charge 22 (telle qu'un haut parleur) et un filtre de type passe bas LC comprenant d'une part une self 30 placée entre la sortie 10 de la batterie et l'entrée de l'amplificateur 20 et d'autre part une capacité 32 placée entre la masse et la sortie de la self 30, c'est-à-dire le point commun à la self 30 et l'entrée de l'amplificateur 20.

Comme on le voit sur la figure 2, selon l'invention il est prévu en outre un interrupteur 40 en parallèle de la self et un moyen 42 conçu pour mesurer un paramètre représentatif de la puissance consommée par le module de sortie constitué par la combinaison de l'amplificateur 20 et de la charge 22. Le moyen 42 est conçu pour court-circuiter la self 30, et donc protéger celle-ci, lorsque le paramètre mesuré dépasse un seuil prédéterminé.

L'interrupteur 40 peut être formé de tous moyens appropriés aptes à court-circuiter la self 30 sur commande des moyens 42. De préférence l'interrupteur 40 est formé d'un transistor ou équivalent.

Les moyens 42 peuvent faire l'objet de différents modes de réalisation. Ils peuvent par exemple mesurer l'intensité du courant à l'entrée ou à la sortie de la self 30, la tension à la sortie de l'amplificateur 20 ou encore des paramètres plus complexes représentant la puissance U.I consommée au niveau de l'amplificateur 20

Selon un mode de réalisation préférentiel, la self 30 est selon la présente invention une self 2A de type SMD permettant un montage en surface en automatique et supportant un procédé de liaison sur un circuit imprimé par procédé de refusion.

Dans ce contexte, selon la présente invention, les moyens 42 sont adaptés pour court-circuiter la self 30 lorsque le courant consommé dépasse 1,5A.

Le dispositif de filtrage conforme à la présente invention opère un filtrage efficace lorsque le courant consommé est faible, inférieur à 1,5A. Au dessus de ce seuil, la self 30 étant court-circuitée, le filtrage n'intervient plus, cependant le bruit de fond devient négligeable par rapport au niveau sonore émis par le module de sortie.

Bien entendu la présente invention n'est pas limitée aux modes de réalisation précédemment décrits, mais s'étend à toutes variantes conformes à son esprit.

L'homme de l'art comprendra que la présente invention permet, sans surcoût, de réaliser un dispositif de filtrage présentant un encombrement inférieur à celui des dispositifs conformes à l'état de la technique, et autorisant un montage en automatique avec procédé de refusion.

## Revendications

1. Dispositif de filtrage d'un circuit d'alimentation électrique d'un amplificateur audio à partir de la batterie d'un véhicule automobile, comprenant une self (30), un interrupteur (40) placé en parallèle de la self (30) et un moyen (42) de mesure d'un paramètre représentatif de la puissance consommée par un module de sortie (20, 22) et de fermeture de l'interrupteur (40) pour court-circuiter la self (30) lorsque ladite puissance consommée est supérieure à un seuil ledit dispositif de filtrage comprenant un filtre passe-bas LC avec d'une part ladite self (30) placée entre la sortie (10) de ladite batterie et l'entrée dudit amplificateur (20) et d'autre part une capacité (32) placée entre la masse et la sortie de ladite self (30), c'est-à-dire le point commun à la self et l'entrée de l'amplificateur (20).

2. Dispositif selon la revendication 1, **caractérisé par le fait que** le moyen de mesure (42) est adapté pour mesurer le courant traversant la self (30).

3. Dispositif selon l'une des revendications 1 ou 2, **caractérisé par le fait que** le moyen de mesure (42) est adapté pour mesurer la tension de sortie d'un amplificateur (20).

4. Dispositif selon l'une des revendications 1 à 3, **caractérisé par le fait que** l'interrupteur (40) est formé d'un transistor.

5. Dispositif selon l'une des revendications 1 à 4, **caractérisé par le fait que** la self (30) est une self 2A.

6. Dispositif selon l'une des revendications 1 à 5, **caractérisé par le fait que** le moyen de mesure (42) est adapté pour fermer l'interrupteur (40) lorsque le courant consommé dépasse 1,5A.

7. Dispositif selon l'une des revendications 1 à 6, **caractérisé par le fait que** la self (30) est une self à montage en surface.

8. Amplificateur audio, **caractérisé par le fait qu'**il comprend un dispositif de filtrage conforme à l'une des revendications 1 à 8.

## Claims

1. Filter device for an audio amplifier electrical power supply circuit using the battery of automobile vehicle, comprising an inductance (30), a switch (40) placed in parallel with the inductance (30) and a means (42) for measuring a parameter representative of the power consumed by an output module (20, 22) and of closing off the switch (40) to short circuit the inductance (30) when said consumed power is greater than a threshold, said filter device comprising a low-pass filter LC with firstly said inductance (30) placed between the output (10) of said battery and the input of said amplifier (20), and secondly a capacitance (32) placed between the ground and the output of said inductance (30), in other words the point common to the inductance and the input to the amplifier (20).

2. Device according to claim 1, **characterised by** the fact that the measurement means (42) is adapted to measure the current passing through the inductance (30).

3. Device according to one of claims 1 or 2, **characterised by** the fact that the measurement means (42) is adapted to measure the output voltage from an amplifier (20).

4. Device according to one of claims 1 to 3, **characterised by** the fact the switch (40) is formed from a transistor.

5. Device according to one of claims 1 to 4, **characterised by** the fact that the inductance (30) is a 2A inductance.

6. Device according to one of claims 1 to 5, **characterised by** the fact that the measurement means (42) is adapted to close off the switch (40) when the consumed current exceeds 1.5A.

7. Device according to one of claims 1 to 6, **characterised by** the fact that the inductance (30) is a surface mounted inductance.

8. Audio amplifier, **characterised by** the fact that it comprises a filter device conforming with one of claims 1 to 7.

## Patentansprüche

1. Filtervorrichtung einer Schaltung für die elektrische Versorgung eines Audioverstärkers ausgehend von der Batterie eines Kraftfahrzeugs, umfassend eine Drossel (30), einen parallel zu der Drossel (30) angeordneten Schalter (40) und ein Mittel (42) zum Messen eines Parameters, der für die Leistung repräsentativ ist, die von einem Ausgangs- (20, 22) verbraucht wird, und zum Schiessen des Schalters (40) um die Drossel (30) kurzzuschließen, wenn die verbrauchte Leistung einen Schwellenwert übersteigt, wobei die Filtervorrichtung einen Tiefpassfilter LC umfasst, mit einerseits der zwischen dem Ausgang (10) der Batterie und dem Eingang des Verstärkers (20) angeordneten Drossel (30) und andererseits einer Kapazität (32), die zwischen der Masse und dem Ausgang der Drossel (30) angeordnet ist, das heißt, dem Verbindungspunkt zwischen der Drossel und dem Eingang des Verstärkers (20).

2. Vorrichtung nach Anspruch 1, **dadurch gekennzeichnet, dass** das Messmittel (42) dazu geeignet ist, den die Drossel (30) durchfliessenden Strom zu messen.

3. Vorrichtung nach einem der Ansprüche 1 oder 2, **dadurch gekennzeichnet, dass** das Messmittel (42) dazu geeignet ist, die Ausgangsspannung eines Verstärkers (20) zu messen.

4. Vorrichtung nach einem der Ansprüche 1 bis 3, **dadurch gekennzeichnet, dass** der Schalter (40) von einem Transistor gebildet ist.

5. Vorrichtung nach einem der Ansprüche 1 bis 4, **dadurch gekennzeichnet, dass** die Drossel (30) eine 2A-Drossel ist.

6. Vorrichtung nach einem der Ansprüche 1 bis 5, **dadurch gekennzeichnet, dass** das Messmittel (42) dazu geeignet ist, den Schalter (40) zu schließen, wenn der verbrauchte Strom 1,5 A übersteigt.

7. Vorrichtung nach einem der Ansprüche 1 bis 6, **dadurch gekennzeichnet, dass** die Drossel (30) eine oberflächenmontierte Drossel ist.

8. Audioverstärker, **dadurch gekennzeichnet, dass** er eine Filtervorrichtung nach einem der Ansprüche 1 bis 8 umfasst.
